# EUROPEAN PATENT SPECIFICATION

(11) **EP 3 146 538 B1**
(45) Date of publication and mention of the grant of the patent: **08.07.2020**
(21) Application number: 15795680.6
(22) Date of filing: 26.05.2015
(51) Int. Cl.: H01F 27/28, H01L 21/02, H01F 17/00, H01L 23/522, H01L 23/532, H01L 23/00, H01L 25/10, H01L 49/02

(54) **METHOD OF MANUFACTURING A MICRO-FABRICATED WAFER LEVEL INTEGRATED INDUCTOR FOR HIGH FREQUENCY SWITCH MODE POWER SUPPLIES**
VERFAHREN ZUR HERSTELLUNG EINES MIKROGEFERTIGTEN INDUKTORS AUF WAFEREBENE FÜR HOCHFREQUENZ-SCHALTNETZTEIL
PROCÉDÉ DE FABRICATION D'UN INDUCTEUR INTÉGRÉ SUR TRANCHE MICRO-USINÉE, POUR BLOCS D'ALIMENTATIONS EN MODE DE COMMUTATION HAUTE FRÉQUENCE

(30) Priority: 23.05.2014 US 201414286562
(43) Date of publication of application: 29.03.2017
(73) Proprietor: Texas Instruments Incorporated, Dallas, TX 75265-5474 (US)
(72) Inventor: LEE, Dok Won, Mountain View, CA 94040 (US); FRENCH, William D., San Jose, CA 95117 (US); PAPOU, Andrei, San Jose, CA 95130 (US)
(74) Representative: Zeller, Andreas
(86) International application number: PCT/US2015/032437
(87) International publication number: WO 2015/179863

(56) References cited:
- EP-A1- 1 063 661
- EP-A1- 2 696 438
- US-A1- 2003 222 295
- US-A1- 2009 068 347
- US-A1- 2009 322 447
- US-A1- 2010 295 649
- US-A1- 2011 217 793
- US-A1- 2011 279 214
- US-A1- 2013 122 628
- US-A1- 2013 224 887
- US-A1- 2014 068 932

## Description

This relates generally to integrated inductors, and more particularly to integrating inductors into wafer level integrated circuit process.

### BACKGROUND

Inductors and transformers may be used in many different types of circuits. For example, they may be used for radio frequency (RF) circuits and high-frequency power distribution or conversion systems, such as a DC-DC voltage (or power) converter. Currently, voltage converters may not be fully integrated on-chip for a variety of reasons. For example, a desired operating frequency may require an inductance value that is unobtainable based on the constrained physical size of the inductor. Further, in particular based on the effects of eddy currents, an on-chip inductor may not have a sufficiently high operating frequency for an RF or high-frequency voltage conversion application.

By integrating a power system, advantages include a DC-DC voltage converter being on the same die as the circuit(s) powered thereby. For example, as processor technology scales to smaller dimensions, supply voltages to circuits within a processor may also scale to smaller values. However, as the dimensions decrease, power consumption of the processor may increase. By using an off-die voltage converter to provide a small supply voltage to a processor with a large power consumption, a large total electrical current is supplied to the processor. This may increase the electrical current per pin or the total number of pins required to power the processor, because each pin has a maximum current handling capability. Also, an increase in supply current can lead to an increase in resistive and inductive voltage drop across various off-die and on-die interconnects, and to a higher cost for decoupling capacitors. By integrating the voltage converter onto the die, these and other problems may be mitigated.

Conventional voltage regulators are built with discrete inductors. The frequency of these regulators has been increasing. By increasing the frequency, the required inductance is allowed to decrease. If the switching frequency is 20MHz, then the required inductor is ∼100nH. US 2003/222295 relates to a high frequency semiconductor transformer. US 2014/068932 relates to a magnetic core inductor integrated with multilevel wiring network.

### SUMMARY

In described examples of an inductor on a wafer level process, high conductive layers, polymer layers, and a magnetic core allow high frequency operation, low RDSON values and high efficiency.

### BRIEF DESCRIPTION OF THE DRAWINGS

FIGS. 1, 2 and 3 are illustrations of steps in fabrication of inductors according to example embodiments.
FIG. 3AA is a cross sectional view of section A-A of FIG 3.
FIG. 3BB is a cross sectional view of section B-B of FIG 3.

### DETAILED DESCRIPTION OF EXAMPLE EMBODIMENTS

In the drawings, like reference numerals are sometimes used to designate like elements. The depictions in the figures are diagrammatic and not to scale. The example embodiments include a technique for manufacturing an on-chip inductor using wafer level processes, and an inductor design that allows high frequency operation, low RDSON values and high efficiency. Embodiments of a laminated magnetic material for inductors in integrated circuits, and the method of manufacture thereof, are described herein.

An integrated magnetic device is disclosed as recited in independent claim 1. A method of forming an integrated magnetic device is recited in independent claim 7. Further embodiments are recited in the dependent claims.

In at least one embodiment, an inductor includes a laminated material structure to decrease eddy currents therein that may limit the operation of the inductor at high frequency. The inductor includes metal lines substantially or completely surrounding a magnetic material. The inductor also includes a laminated magnetic layer or layers that further include higher resistance or insulator layers. The increased resistance of the laminated magnetic layers may reduce eddy currents within the inductor and subsequently improve the performance of the inductor at higher frequencies. An embodiment may employ electroplating, electro less plating or sputtering techniques to form a layer or layers of magnetic material, and in particular those layers adjacent to insulator layers.

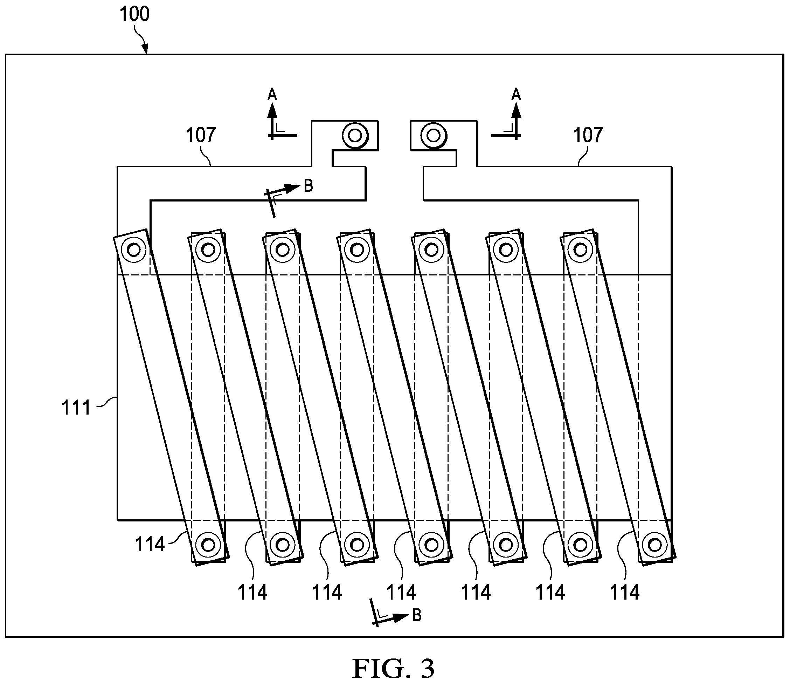

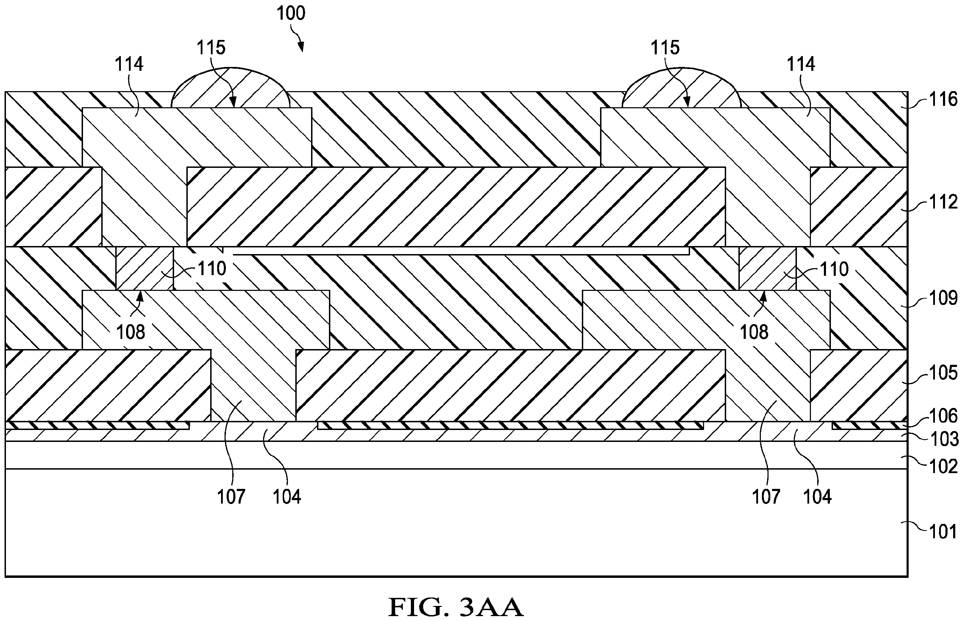

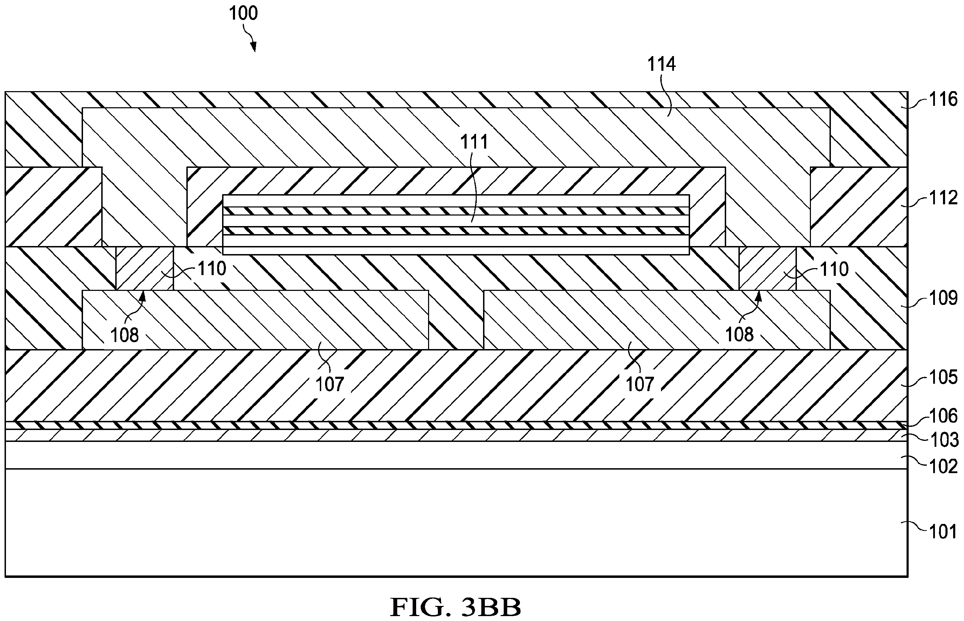

FIGS. 3AA and 3BB are cross sectional views of sections A-A and B-B of FIG. 3, respectively. In an example embodiment 100, FIG. 3AA has a silicon wafer substrate 101. An active region 102 includes transistors, diodes, capacitors and resistors coupled by conductive interconnect layer 103 to form an active circuit. The active region 102 touches the top surface of the silicon wafer substrate and includes a first plurality of bond contacts 104. The conductive interconnect layer 103 can include multiple layers of conductive material with insulating layer therebetween. The multiple layers of conductive material can be coupled together by a plurality of vias piercing their associated insulating layer. The top of the conductive interconnect layer 103 is an insulating layer, having openings to expose a first plurality of bond contacts 104. Also, the insulating layer on top of the conductive interconnect layer can be covered by a silicon nitride layer 106, having openings to expose the first plurality of bond contacts 104.

A first layer of polymer 105 can be deposited on top of the silicon nitride layer and also include a first plurality openings extending from the top of the first layer of polymer down to the first plurality of bond contacts 104. The first layer of polymer 105 can act as a stress relief layer between the inductor and the silicon wafer. It can be between 5um-15um in thickness. This can also act to reduce coupling between the copper windings and the silicon wafer substrate 101. The first layer of polymer can be chosen from the group of polymers SU8 or PI-2622.

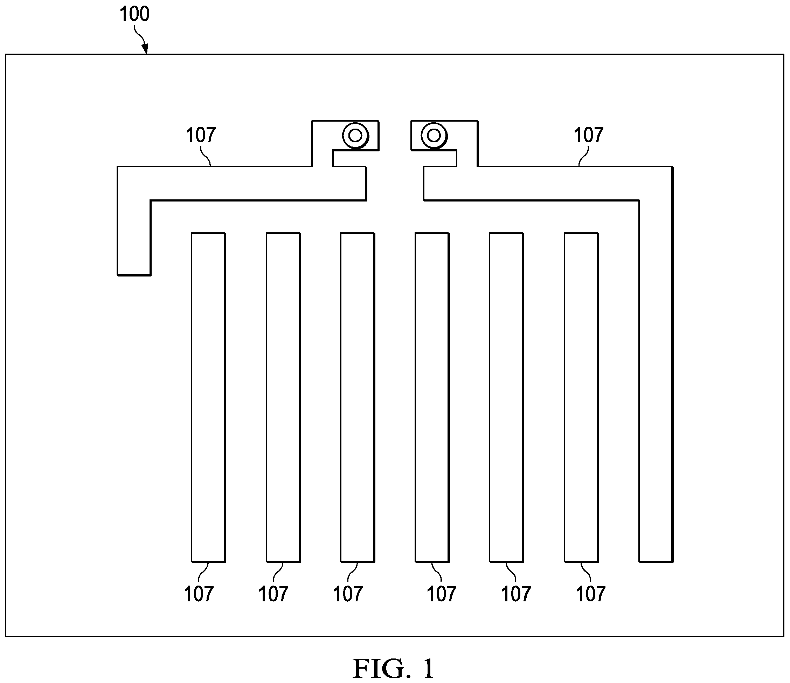

A first layer of high conductance material 107 FIG. 1 can be deposited on the top surface of the first layer of polymer 105, filling the openings in the first polymer layer, thereby coupling the first layer of high conductance material 107 to the first plurality of bond contacts 104. The first layer of high conductance material 107 can also be configured to form a plurality of lower coil members and also includes a second plurality of bond contacts 108. The first layer of high conductance material 107 can include copper with a thickness of 20µm.

A second layer of polymer 109 touches the first layer of polymer 105 and the first layer of high conductance material 107. The top surface of the second layer of polymer is planar. The second layer of polymer 109 can include openings extending from the top surface of the second layer of polymer 109 down to the second plurality of contacts 108. The openings in the second layer of polymer can be filled with a first plurality of vias 110. The first plurality of vias 110 can be copper. The second layer of polymer 109 can be chosen from the group of polymers SU8 3000 or PI-2622

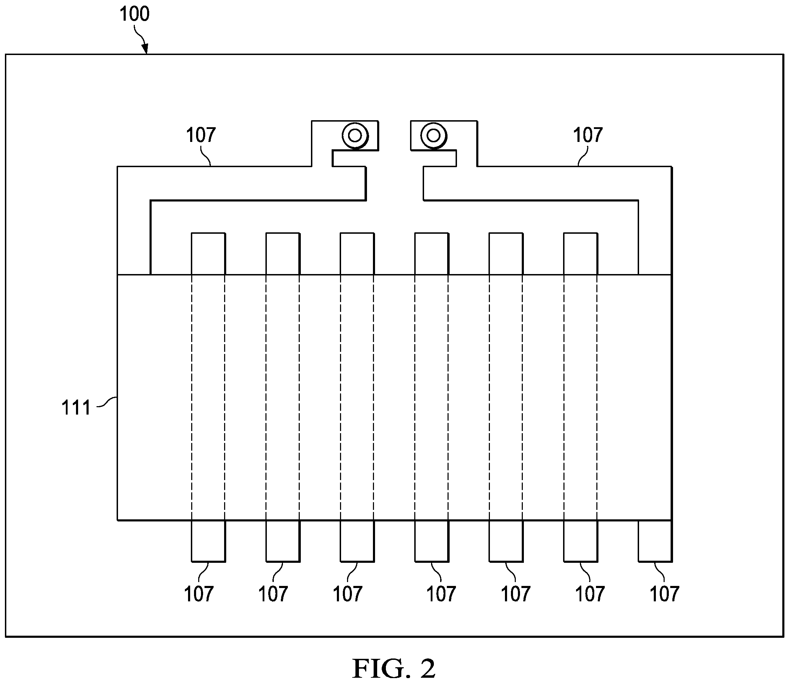

Multiple layers of alternating magnetic material and insulating material 111 FIG. 2 can be deposited and defined on the top surface of second layer of polymer 109. The multiple layers of alternating magnetic material and insulating material 111, as defined, do not touch the first plurality of vias 110 exposed on the top surface of the second layer of polymer 109.

Each magnetic film layer can have thickness ranges from 0.1µm to 3µm with a 10nm AlN dielectric in between. The magnetic layers can be selected from the group of Ni80Fe20, Co90Ta5Zr5 or FeAlN. The laminated magnetic core total thickness can be between 5-15µm.

A third layer of polymer 112 can be deposited next, touching the second layer of polymer 109 and the top of the multiple layers of alternating magnetic material and insulating material 111. The third layer of polymer can include openings extending from the top surface of the third layer of polymer 112 down to the top surfaces of the first plurality of vias 110.

A second layer of high conductance material 114 (FIG. 3) can be deposited on the top surface of the third layer of polymer 112. The second layer of high conductance material 114 fills the openings in the third polymer layer 112, thereby coupling the second layer of high conductance material 114 to the first plurality of bond contacts 104. The third layer of high conductance material 114 can also be configured to form a plurality of upper coil members and also includes a third plurality of bond contacts 115. The second layer of high conductance material 114 can include copper with a thickness of 20µm.

A fourth layer of polymer 116 can be deposited next, touching the third layer of polymer 112 and the top of the second layer of high conductance material 114. The fourth layer of polymer can include openings extending from the top surface of the fourth layer of polymer 112 down to the second layer of high conductance material 114. The openings in the fourth layer of polymer can be filled with solder balls 116. The solder balls provide connection to outside circuitry.

In accordance with another embodiment, the wafer level integrated inductor is fabricated by providing a conventionally formed integrated circuit wafer 101, 102 and 103. The bond contacts 104 of each of the integrated circuits are exposed through openings in the insulating layer at the top of the conductive interconnect layer 103.

A layer of silicon nitride is deposited over the wafer, touching the insulating layer at the top of the conductive interconnect layer 103 and the bond pads 104 exposed through the openings in the insulating layer at the top of the conductive interconnect layer 103. Using a pattern and etch process, the bond contacts 104 are exposed through openings in the silicon nitride layer.

A first layer of polymer 105, chosen from the group of polymers SU8 or PI-2622 is spun onto the wafer.

If the first layer of polymer 105 spun onto the wafer is PI-2622, then it is then baked to cure the polymer layer. A patterned hard mask is deposited on the wafer touching the top surface of the first polymer 105. Openings are etched into the first polymer layer 105 extending from the top surface of the first polymer layer 105 down to the plurality of bond contacts 104. The first layer of polymer is configured to act as a stress relief layer between an inductor and the silicon wafer. The thickness of the first layer of polymer is between 5µm-15µm. The hard mask is then removed.

If the first layer of polymer 105 spun onto the wafer is SU8, then it is then soft baked. A photoresist layer is deposited and patterned, in which an exposure by a light source occurs. After exposure, a post exposure bake is performed. The photoresist and the unexposed SU8 is then developed off. The SU8 is then hard baked after developing. The SU8 exposed to the light source will remain on the wafer after the developing process.

A first seed layer of Ti/Cu is sputtered on the top surface of the first layer of polymer 105.

A photoresist layer is spun onto the wafer and patterned using standard photo lithography processes.

A first layer of high conductance material 107 is then electroplated onto the surface of the photoresist and into the open areas defined by the photoresist, touching the first seed layer on the first polymer layer 105 and defining a plurality of lower coil members 107 which include a second plurality of contacts 108, while filling the openings in the first polymer layer 105, thereby coupling the first layer of high conductance material to the first plurality of bond contacts 104. The first layer of high conductance material can be composed of 20µm of copper. The photoresist layer is stripped using standard photo stripping methods. Following the photoresist strip, the exposed first seed layer is dry etched.

A second layer of polymer 109 is spun onto the wafer and baked to cure the polymer layer. A patterned hard mask is deposited on the wafer touching the top surface of the second polymer 109. Openings are etched into the second polymer layer 109 extending from the top surface of the second polymer layer 109 down to the plurality of bond contacts 108. The hard mask is then removed.

The second layer of polymer 109 can be chosen from the group of polymers SU8 3000 or PI-2622. If PI-2622 is used, then a CMP process can be used to planarize the surface. If SU8 3000 is used instead of PI-2622 for the second Polymer layer 109, then CMP is not required because SU8 3000 is largely self-planarizing to the required tolerance.

A second seed layer of Ti/Cu is sputtered on the top surface of the second layer of polymer 109 touching the second layer of polymer 109 and the tops of the second plurality of contacts 108.

A photoresist layer is spun onto the wafer and patterned using standard photo lithography processes.

A layer of high conductance material is then electroplated into the open areas defied by the photoresist, touching the second seed layer on the second polymer layer 109, filling the openings in the second polymer layer 109, defining a first plurality vias 110, thereby coupling the plurality of vias to the first plurality of bond contacts 104. The second layer of high conductance material can be composed of 20µm of copper. The photoresist layer is stripped using standard photo stripping methods. Following the photoresist strip, the exposed first seed layer is dry etched.

A layer of titanium is sputtered on the top surface of the second layer of polymer, touching the second layer of polymer and the tops of the first plurality of vias 110.

A laminated magnetic core 111 including multiple layers of alternating magnetic material and insulating material FIG. 2 can be deposited using a Veeco Nexus PVDi Tool in a magnetic field on the top surface of the layer of titanium. The multiple layers of alternating magnetic material and insulating material 111 are defined to not touch the first plurality of vias 110 exposed on the top surface of the second layer of polymer 109.

Each magnetic film layer can be sputtered, with thickness ranges from 0.1µm to 3µm with a 10nm A1N dielectric therebetween. Sputtering can be in the presence of a magnetic field to determine the easy axis of the magnetic material. The orientation is such that the B-field in the multiple layers of alternating magnetic material and insulating material 111 is in the direction of the hard axis. The magnetic layers can be selected from the group of Ni80Fe20, Co90Ta5Zr5 or FeAlN. The magnetic layers can be subjected to an anneal (300-500C) in the presence of a magnetic field after sputtering. This acts to further define the easy/hard axes. The laminated magnetic core 111 total thickness can be between 5-15µm

Standard photo resist process can be used to pattern and etch the laminated magnetic core 111. The multiple layers of alternating magnetic material and insulating material and the Ti adhesion layer can then be etched. The photoresist is then stripped using standard techniques.

A third layer of polymer 112 is spun onto the wafer and baked to cure the polymer layer. A patterned hard mask is deposited on the wafer touching the top surface of the third polymer layer 112. Openings are etched into the third polymer layer 112 extending from the top surface of the third polymer layer 112 down to the first plurality of vias 110. The hard mask is then removed.

A third seed layer of Ti/Cu is sputtered on the top surface of the third layer of polymer 112 touching the third layer of polymer 112 and the tops of the first plurality of vias 110.

A photoresist layer is spun onto the wafer and patterned using standard photo lithography processes.

A second layer of high conductance material 114 is then electroplated onto the surface of the photoresist and into the open areas defied by the photoresist, touching the third seed layer on the third polymer layer 112 and defining a plurality of upper coil members 114 which include a second plurality of contacts 115, while filling the openings in the third polymer layer 112, thereby coupling the second layer of high conductance material to the first plurality of bond contacts 104. The second layer of high conductance material can be composed of 20µm of copper. The photoresist layer is stripped using standard photo stripping methods. Following the photoresist strip, the exposed first seed layer is dry etched.

A fourth layer of polymer 116 is spun onto the wafer and baked to cure the polymer layer. A patterned hard mask is deposited on the wafer touching the top surface of the fourth polymer layer 116. Openings are etched into the third polymer layer 116 extending from the top surface of the fourth polymer layer 116 down to the second plurality of contacts 115. The hard mask is then removed.

The magnetic layers can be subjected to a second anneal (300-500C) in the presence of a magnetic field (0.1-1T). This acts to further define the easy/hard axes.

Finally, solder bumps are formed in the openings formed in the fourth layer of polymer 116 touching the third layer of high conductance material 114, thereby coupling to the first plurality of bond contacts 104.

Accordingly, in described examples, an integrated magnetic device includes a silicon wafer substrate. An active region thereupon includes transistors, diodes, capacitors and resistors coupled by a conductive interconnect layer to form an active circuit. The active region touches the top surface of the silicon wafer substrate and includes a first plurality of bond contacts. The conductive interconnect layer includes multiple layers of conductive material with insulating layer therebetween. The multiple layers of conductive material are coupled together by a first plurality of vias piercing their associated insulating layer. The top of the conductive interconnect layer is an insulating layer, having openings to expose a first plurality of bond contacts. Further, the integrated magnetic device includes a silicon nitride layer overlaying and touching the insulating layer, also having openings to expose the first plurality of bond contacts. A first layer of polymer is deposited on top of the silicon nitride layer, including a first plurality openings extending from the top of the first layer of polymer down to the first plurality of bond contacts. A first layer of high conductance material is deposited on the top surface of the first layer of polymer, filling the first plurality of openings in the first polymer layer, forming the second plurality of vias, thereby coupling the first layer of high conductance material to the first plurality of bond contacts. The first layer of high conductance material is configured to form a plurality of lower coil members and also includes a second plurality of bond contacts. A second layer of polymer touches the first layer of polymer and the first layer of high conductance material. The top surface of the second layer of polymer is planar. The second layer of polymer includes a second plurality of openings extending from the top surface of the second layer of polymer down to the second plurality of bond contacts. The second plurality of openings in the second layer of polymer are filled with a third plurality of vias. Multiple layers of alternating magnetic film material and insulating material are deposited and defined on the top surface of second layer of polymer. The multiple layers of alternating magnetic film material and insulating material, as defined, do not touch the third plurality of vias exposed on the top surface of the second layer of polymer. A third layer of polymer is deposited touching the second layer of polymer and the top of the multiple layers of alternating magnetic material and insulating material. The third layer of polymer includes a third plurality of openings extending from the top surface of the third layer of polymer down to the top surfaces of the third plurality of vias. A second layer of high conductance material is deposited on the top surface of the third layer of polymer. The second layer of high conductance material fills the third plurality of openings in the third polymer layer, forming a fourth plurality of vias, thereby coupling the second layer of high conductance material to the first plurality of bond contacts. The third layer of high conductance material is configured to form a plurality of upper coil members and also includes a third plurality of bond contacts. A fourth layer of polymer is deposited touching the third layer of polymer and the top of the second layer of high conductance material. The fourth layer of polymer includes openings extending from the top surface of the fourth layer of polymer down to the second layer of high conductance material. The openings in the fourth layer of polymer are filled with solder balls, which provide connection to outside circuitry.

In other described examples, a method of forming an integrated magnetic device includes providing a conventionally formed integrated circuit wafer. Bond contacts of each of the integrated circuits are exposed through openings in the insulating layer at the top of the conductive interconnect layer. The method includes depositing and defining a layer of silicon nitride over the wafer, wherein the silicon nitride layer touches the insulating layer at the top of the conductive interconnect layer and exposes the bond pads exposed through the openings in the insulating layer at the top of the conductive interconnect layer. By using a pattern and etch process, the bond contacts are exposed through openings in the silicon nitride layer. Also, the method includes spinning and patterning a first layer of polymer onto the wafer chosen from the group of polymers SU8 or PI-2622; sputtering a first seed layer of Ti/Cu on the top surface of the first layer of polymer; and spinning and patterning a photoresist layer on the first seed layer using standard photo lithography processes. Further, the method includes electroplating a first layer of high conductance material on the surface of the photoresist and into the open areas defined by the photoresist, touching the first seed layer and defining a plurality of lower coil members which include a second plurality of contacts, and filling the first plurality of openings in the first polymer layer, thereby coupling the first layer of high conductance material to the first plurality of bond contacts. Moreover, the method includes stripping the photoresist layer, using standard photoresist stripping methods, and dry etching the exposed first seed layer; spinning a second layer of polymer onto the wafer, and baking it to cure the polymer layer; and depositing a patterned hard mask on the wafer touching the top surface of the second polymer. A second plurality of openings are etched into the second polymer layer extending from the top surface of the second polymer layer down to the second plurality of contacts. Also, the method includes removing the hard mask; sputtering a second seed layer of Ti/Cu on the top surface of the first layer of polymer; spinning and patterning a photoresist layer on the second seed layer using standard photo lithography processes; electroplating a layer of high conductance material into the open areas defined by the photoresist, touching the second seed layer and defining a first plurality of vias, thereby coupling the first plurality of vias to the first plurality of bond contacts. Further, the method includes stripping the photoresist layer, using standard photoresist stripping methods and dry etching the exposed second seed layer; sputtering a layer of titanium on the top surface of the second layer of polymer, touching the second layer of polymer and the tops of the first plurality of vias; and depositing a laminated magnetic core including multiple layers of alternating magnetic film material and insulating material using a Veeco Nexus PVDi Tool, in a magnetic field, on the top surface of the layer of titanium. The multiple layers of alternating magnetic material and insulating material are defined to not touch the first plurality of vias exposed on the top surface of the second layer of polymer. Moreover, the method includes patterning and etching of the multiple layers of alternating magnetic material and insulating material and the titanium layer, using standard photo resist processes. The photoresist is then stripped using standard techniques. Also, the method includes spinning a third layer of polymer onto the wafer and baking it to cure the polymer layer; depositing a patterned hard mask on the wafer touching the top surface of the third polymer layer, wherein a third plurality of openings are etched into the third polymer layer extending from the top surface of the third polymer layer down to the first plurality vias; removing the hard mask; sputtering a third seed layer of Ti/Cu on the top surface of the third layer of polymer; spinning and patterning a photoresist layer on the third seed layer using standard photo lithography processes; and electroplating a second layer of high conductance material on the surface of the photoresist and into the open areas defined by the photoresist, touching the third seed layer and defining a plurality of upper coil members which include a second plurality of contacts, and filling the third plurality of openings in the third polymer layer, thereby coupling the second layer of high conductance material to the first plurality of bond contacts. Further, the method includes stripping the photoresist layer, using standard photoresist stripping methods, and dry etching the exposed first seed layer; depositing a fourth layer of polymer, touching the third layer of polymer and the second layer of high conductance material, wherein the fourth layer of polymer includes openings extending from the top surface of the fourth layer of polymer down through the fourth layer of polymer to the second layer of high conductance material; subjecting the magnetic layers to a second anneal (300-500C) in the presence of a magnetic field (0.1-1T), wherein the second anneal further defines the easy/hard axes; and forming solder bumps in the openings formed in the fourth layer of polymer, touching the second layer of high conductance material.

Modifications are possible in the described embodiments, and other embodiments are possible, within the scope of the claims.

## Claims

1. An integrated magnetic device, comprising:
a silicon wafer substrate (101), an active region (102) thereupon including transistors, diodes, capacitors and resistors coupled by a conductive interconnect layer (103) to form an active circuit, wherein the active region (102) touches the top surface of the silicon wafer substrate (101) and includes a first plurality of bond contacts (104), wherein the conductive interconnect layer (103) includes multiple layers of conductive material with insulating layer therebetween, the multiple layers of conductive material coupled together by a first plurality of vias (110) piercing their associated insulating layer, wherein the top of the conductive interconnect layer (103) is an insulating layer, having openings to expose the first plurality of bond contacts (104);
a silicon nitride layer (106) overlaying and touching the insulating layer, also having openings to expose the first plurality of bond contacts (104);
a first layer of polymer (105) deposited on top of the silicon nitride layer (106), including a first plurality openings extending from the top of the first layer of polymer (105) down to the first plurality of bond contacts (104);
a first layer of high conductance material (107), deposited on the top surface of the first layer of polymer (105), filling the first plurality of openings in the first polymer layer (105), forming the second plurality of vias, thereby coupling the first layer of high conductance material (107) to the first plurality of bond contacts (104), wherein the first layer of high conductance material (107) is configured to form a plurality of lower coil members and also includes a second plurality of bond contacts (108);
a second layer of polymer (109), touching the first layer of polymer (105) and the first layer of high conductance material (107), wherein the top surface of the second layer of polymer (109) is planar, the second layer of polymer (109) including a second plurality of openings extending from the top surface of the second layer of polymer (109) down to the second plurality of bond contacts (108), wherein the second plurality of openings in the second layer of polymer (109) are filled with a third plurality of vias;
multiple layers of alternating magnetic film material and insulating material (111) deposited and defined on the top surface of second layer of polymer (109), wherein the multiple layers of alternating magnetic film material and insulating material (111), as defined, do not touch the third plurality of vias exposed on the top surface of the second layer of polymer (109);
a third layer of polymer (112) is deposited touching the second layer of polymer (109) and the top of the multiple layers of alternating magnetic material and insulating material (111), the third layer of polymer (112) includes a third plurality of openings extending from the top surface of the third layer of polymer (112) down to the top surfaces of the third plurality of vias;
a second layer of high conductance material (114) is deposited on the top surface of the third layer of polymer (112), wherein the second layer of high conductance material (114) fills the third plurality of openings in the third polymer layer (112), forming a fourth plurality of vias, thereby coupling the second layer of high conductance material (114) to the first plurality of bond contacts (104), the second layer of high conductance material (114) is configured to form a plurality of upper coil members and also includes a third plurality of bond contacts (115); and
a fourth layer of polymer (116) is deposited touching the third layer of polymer (112) and the top of the second layer of high conductance material (114), wherein the fourth layer of polymer (116) includes openings extending from the top surface of the fourth layer of polymer (116) down to the second layer of high conductance material (114), the openings in the fourth layer of polymer (116) are filled with solder balls, wherein the solder balls provide connection to outside circuitry.

2. The integrated magnetic device of claim 1, wherein the first layer of polymer (105) is configured to act as a stress relief layer between an inductor and the silicon wafer, wherein the thickness of the first layer of polymer (105) is between 5µm-15µm, and the first layer of polymer (105) is chosen from the group of polymers SU8 or PI-2622.

3. The integrated magnetic device of claim 1, wherein the second layer of polymer (109) is chosen from the group of polymers SU8 3000 or PI-2622.

4. The integrated magnetic device of claim 1, wherein each magnetic film layer has a thickness that ranges from 0.1µm to 3µm with a 10nm AlN dielectric in between, and the composition of the magnetic film layers are selected from the group of Ni80Fe20, Co90Ta5Zr5 or FeAlN.

5. The integrated magnetic device of claim 1, wherein the laminated magnetic core total thickness is between 5-15µm.

6. The integrated magnetic device of claim 1, wherein the first and second layers of high conductance material include copper with a thickness of 20µm.

7. A method of forming an integrated magnetic device, comprising:
providing a conventionally formed integrated circuit wafer wherein bond contacts of each of the integrated circuits are exposed through openings in the insulating layer at the top of the conductive interconnect layer (103);
depositing and defining a layer of silicon nitride over the wafer, wherein the silicon nitride layer (106) touches the insulating layer at the top of the conductive interconnect layer (103) and exposes the bond pads exposed through the openings in the insulating layer at the top of the conductive interconnect layer (103); and by using a pattern and etch process, the bond contacts are exposed through openings in the silicon nitride layer (106);
spinning and patterning a first layer of polymer (105) onto the wafer;
sputtering a first seed layer of Ti/Cu on the top surface of the first layer of polymer (105);
spinning and patterning a photoresist layer on the first seed layer using standard photo lithography processes;
electroplating a first layer of high conductance material (107) on the surface of the photoresist and into the open areas defined by the photoresist, touching the first seed layer and defining a plurality of lower coil members which include a second plurality of contacts, filling the first plurality of openings in the first polymer layer, thereby coupling the first layer of high conductance material (107) to the first plurality of bond contacts (104);
stripping the photoresist layer, using standard photoresist stripping methods and dry etching the exposed first seed layer;
spinning a second layer of polymer (109) onto the wafer, and baking it to cure the polymer layer;
depositing a patterned hard mask on the wafer touching the top surface of the second polymer, wherein a second plurality of openings are etched into the second polymer layer extending from the top surface of the second polymer layer down to the second plurality of contacts;
removing the hard mask;
sputtering a second seed layer of Ti/Cu on the top surface of the first layer of polymer (105);
spinning and patterning a photoresist layer on the second seed layer using standard photo lithography processes;
electroplating a layer of high conductance material into the open areas defined by the photoresist, touching the second seed layer and defining a first plurality of vias (110), thereby coupling the first plurality of vias (110) to the first plurality of bond contacts (104);
stripping the photoresist layer, using standard photoresist stripping methods and dry etching the exposed second seed layer;
sputtering a layer of titanium on the top surface of the second layer of polymer (109), touching the second layer of polymer (109) and the tops of the first plurality of vias (110);
depositing a laminated magnetic core including multiple layers of alternating magnetic film material and insulating material (111) using a Veeco Nexus PVDi Tool, in a magnetic field, on the top surface of the layer of titanium, wherein the multiple layers of alternating magnetic material and insulating material are defined to not touch the first plurality of vias (110) exposed on the top surface of the second layer of polymer (109);
patterning and etching of the multiple layers of alternating magnetic material and insulating material and the titanium layer, using standard photo resist processes, wherein the photoresist is then stripped using standard techniques;
spinning a third layer of polymer (112) onto the wafer and baking it to cure the polymer layer;
depositing a patterned hard mask on the wafer touching the top surface of the third polymer layer, wherein a third plurality of openings are etched into the third polymer layer extending from the top surface of the third polymer layer down to the first plurality vias;
removing the hard mask;
sputtering a third seed layer of Ti/Cu on the top surface of the third layer of polymer (112);
spinning and patterning a photoresist layer on the third seed layer using standard photo lithography processes;
electroplating a second layer of high conductance material (114) on the surface of the photoresist and into the open areas defined by the photoresist, touching the third seed layer and defining a plurality of upper coil members which include a second plurality of contacts, and filling the third plurality of openings in the third polymer layer, thereby coupling the second layer of high conductance material (114) to the first plurality of bond contacts (104);
stripping the photoresist layer, using standard photoresist stripping methods, and dry etching the exposed first seed layer;
depositing a fourth layer of polymer (116), touching the third layer of polymer (112) and the second layer of high conductance material (114), wherein the fourth layer of polymer (116) includes openings extending from the top surface of the fourth layer of polymer (116) down through the fourth layer of polymer (116) to the second layer of high conductance material (114);
subjecting the magnetic layers to a second anneal (300-500C) in the presence of a magnetic field (0.1-1T), wherein the second anneal further defines the easy/hard axes; and
forming solder bumps in the openings formed in the fourth layer of polymer (116), touching the second layer of high conductance material (114).

8. The method of forming an integrated magnetic device of claim 7, wherein the second layer of polymer (109) is chosen from the group of polymers SU8 3000 or PI-2622, wherein if PI-2622 is chosen, a CMP process is used to planarize the surface, and wherein if SU8 3000 is used instead of PI-2622 for the second Polymer layer, CMP is not required because SU8 3000 is largely self-planarizing to the required tolerance.

9. The method of forming an integrated magnetic device of claim 7, wherein each magnetic film layer is sputtered, with thickness ranges from 0.1µm to 3µm with a 10nm AlN dielectric therebetween, wherein the total laminated magnetic thickness is between 5-15µm, the sputtering is accomplished in the presence of a magnetic field to determine the easy axis of the magnetic material, and wherein the orientation is such that the B-field in the multiple layers of alternating magnetic material and insulating material is in the direction of the hard axis.

10. The method of forming an integrated magnetic device of claim 7, wherein the magnetic film layers can be selected from the group of Ni80Fe20, Co90Ta5Zr5 or FeAlN.

11. The method of forming an integrated magnetic device of claim 7, wherein the magnetic film layers are subjected to an anneal of 300-500°C, in the presence of a magnetic field after sputtering, further defining the easy/hard axes.

12. The method of forming an integrated magnetic device of claim 7, wherein the first and second layers of high conductance material include copper with a thickness of 20µm.

13. The method of forming an integrated magnetic device of claim 7, wherein the first layer of polymer (105) is configured to act as a stress relief layer between an inductor and the silicon wafer, wherein the thickness of the first layer of polymer (105) is between 5µm-15µm, and the first layer of polymer (105) is chosen from the group of polymers SU8 or PI-2622.

14. The method of forming an integrated magnetic device of claim 7, wherein the first layer of polymer (105) is PI-2622, and is then baked after spinning to cure the polymer layer, depositing a patterned hard mask on the wafer touching the top surface of the first polymer layer, wherein a first plurality of openings are etched into the first polymer layer extending from the top surface of the first polymer layer down to the plurality of bond contacts, removing the hard mask.

15. The method of forming an integrated magnetic device of claim 7, wherein the first layer of polymer (105) is SU8, is then soft baked after spinning, depositing and patterning a photoresist layer on the wafer touching the top surface of the first polymer layer, wherein an exposure by a light source takes place, following the exposure, a post exposure bake is performed, wherein the photoresist and the unexposed SU8 is then developed off, wherein the SU8 is then hard baked after developing, and the SU8 exposed to the light source will remain on the wafer after the developing process.

## Patentansprüche

1. Integrierte magnetische Vorrichtung, die Folgendes umfasst:
ein Siliziumwafer-Substrat (101), einen aktiven Bereich (102), auf dem Transistoren, Dioden, Kondensatoren und Widerstände enthalten sind, die durch eine leitfähige Zwischenverbindungsschicht (103) gekoppelt sind, um eine aktive Schaltung zu bilden, wobei der aktive Bereich (102) die obere Oberfläche des Siliziumwafer-Substrats (101) berührt und mehrere erste Bondkontakte (104) enthält, wobei die leitfähige Zwischenverbindungsschicht (103) mehrere Schichten leitfähigen Materials mit Isolierschichten dazwischen enthält, wobei die mehreren Schichten leitfähigen Materials durch mehrere erste Durchkontaktierungen (110), die ihre zugehörigen Isolierschichten lochen, zusammen gekoppelt sind, wobei die Oberseite der leitfähigen Zwischenverbindungsschicht (103) einer Isolierschicht entspricht, die Öffnungen aufweist, um die mehreren ersten Bondkontakte (104) freizulegen;
eine Siliziumnitrid-Schicht (106), die die Isolierschicht überzieht und berührt, die ebenfalls Öffnungen aufweist, um die mehreren ersten Bondkontakte (104) freizulegen;
eine erste Polymer-Schicht (105), die auf der Oberseite der Siliziumnitrid-Schicht (106) abgelagert wird, die mehrere erste Öffnungen enthält, die sich von der Oberseite der ersten Polymerschicht (105) nach unten zu den mehreren ersten Bondkontakten (104) erstrecken;
eine erste Schicht aus Material (107) mit hoher Leitfähigkeit, die auf der oberen Oberfläche der ersten Polymerschicht (105) abgelagert worden ist, die die mehreren ersten Öffnungen in der ersten Polymerschicht (105) füllt, wobei sie die mehreren zweiten Durchkontaktierungen bildet, wodurch die erste Schicht aus Material (107) mit hoher Leitfähigkeit an die mehreren ersten Bondkontakte (104) koppelt, wobei die erste Schicht aus Material (107) mit hoher Leitfähigkeit konfiguriert ist, mehrere untere Spulenelemente zu bilden, und ebenfalls mehrere zweite Bondkontakte (108) enthält;
eine zweite Polymerschicht (109), die die erste Polymerschicht (105) und die erste Schicht aus Material (107) mit hoher Leitfähigkeit berührt, wobei die obere Oberfläche der zweiten Polymerschicht (109) eben ist, und die zweite Polymerschicht (109) mehrere zweite Öffnungen enthält, die sich von der oberen Oberfläche der zweiten Polymerschicht (109) nach unten zu den mehreren zweiten Bondkontakten (108) erstrecken, wobei die mehreren zweiten Öffnungen in der zweiten Polymerschicht (109) mit mehreren dritten Durchkontaktierungen gefüllt sind;
mehrere Schichten aus abwechselnd Magnetfilmmaterial und isolierendem Material (111), die auf der oberen Oberfläche der zweiten Polymerschicht (109) abgelagert und definiert worden sind, wobei die mehreren Schichten aus abwechselnd Magnetfilmmaterial und isolierendem Material (111), wie definiert, die mehreren dritten Durchkontaktierungen, die auf der oberen Oberfläche der zweiten Polymerschicht (109) freigelegt sind, nicht berühren;
eine dritte Polymerschicht (112), die abgelagert ist, wobei sie die zweite Polymerschicht (109) und die Oberseite der mehreren Schichten aus abwechselnd Magnetfilmmaterial und
isolierendem Material (111) berührt, wobei die dritte Polymerschicht (112) mehrere dritte Öffnungen enthält, die sich von der oberen Oberfläche der dritten Polymerschicht (112) nach unten zu den oberen Oberflächen der mehreren dritten Durchkontaktierungen erstrecken;
eine zweite Schicht aus Material (114) mit hoher Leitfähigkeit, die auf der oberen Oberfläche der dritten Polymerschicht (112) abgelagert ist, wobei die zweite Schicht aus Material (114) mit hoher Leitfähigkeit die mehreren dritten Öffnungen in der dritten Polymerschicht (112) füllt, wobei sie mehrere vierten Durchkontaktierungen bilden, wodurch die zweite Schicht aus Material (114) mit hoher Leitfähigkeit mit den mehreren ersten Bondkontakten (104) koppelt, wobei die zweite Schicht aus Material (114) mit hoher Leitfähigkeit konfiguriert ist, mehrere obere Spulenelemente zu bilden, und ebenfalls mehrere dritte Bondkontakte (115) enthält; und
eine vierte Polymerschicht (116), die abgelagert wird, wobei sie die dritte Polymerschicht (112) und die Oberseite der zweiten Schicht aus Material (114) mit hoher Leitfähigkeit berührt, wobei die vierte Polymerschicht (116) Öffnungen enthält, die sich von der oberen Oberfläche der vierten Polymerschicht (116) nach unten zu der zweiten Schicht aus Material (114) mit hoher Leitfähigkeit erstreckt, wobei die Öffnungen in der vierten Polymerschicht (116) mit Lotkugeln gefüllt sind, wobei die Lotkugeln eine Verbindung zu einer äußeren Schaltungsanordnung bereitstellen.

2. Integrierte magnetische Vorrichtung nach Anspruch 1, wobei die erste Polymerschicht (105) konfiguriert ist, als eine Spannungsentlastungsschicht zwischen einer Induktivität und dem Siliziumwafer zu agieren, wobei die Dicke der ersten Polymerschicht (105) zwischen 5 µm und 15 µm beträgt, und die erste Polymerschicht (105) aus der Gruppe der Polymere SU8 oder PI-2622 ausgewählt wird.

3. Integrierte magnetische Vorrichtung nach Anspruch 1, wobei die zweite Polymerschicht (109) aus der Gruppe der Polymere SU8 3000 oder PI-2622 ausgewählt wird.

4. Integrierte magnetische Vorrichtung nach Anspruch 1, wobei jede Magnetfilm-Schicht eine Dicke aufweist, die, mit einem 10 nm AlN-Dielektrikum dazwischen, in einem Bereich von 0,1 µm bis 3 µm liegt, und die Zusammensetzung der Magnetfilm-Schichten aus der Gruppe von Ni80Fe20, Co90Ta5Zr5 oder FeAlN ausgewählt wird.

5. Integrierte magnetische Vorrichtung nach Anspruch 1, wobei die Gesamtdicke des lamellierten Magnetkerns zwischen 5 µm und 15 µm beträgt.

6. Integrierte magnetische Vorrichtung nach Anspruch 1, wobei die erste und zweite Schicht aus Material mit hoher Leitfähigkeit Kupfer mit einer Dicke von 20 µm enthalten.

7. Verfahren zum Bilden einer integrierten magnetischen Vorrichtung, das Folgendes umfasst:
Bereitstellen eines konventionell gebildeten integrierten Schaltungswafers, wobei Bondkontakte jeder der integrierten Schaltungen durch Öffnungen in der Isolierschicht an der Oberseite der leitfähigen Zwischenverbindungsschicht (103) freigelegt sind;
Ablagern und Definieren einer Schicht aus Siliziumnitrid über dem Wafer, wobei die Siliziumnitridschicht (106) die Isolierschicht an der Oberseite der leitfähigen Zwischenverbindungsschicht (103) berührt und die Bondinseln freilegt, die durch die Öffnungen in der Isolierschicht auf der Oberseite der leitfähigen Zwischenverbindungsschicht (103) freigelegt sind; und durch Verwenden einer Struktur und eines Ätzprozesses, die Bondkontakte durch die Öffnungen in der Siliziumnitridschicht (106) freigelegt werden;
Spinnen und Strukturieren einer ersten Polymerschicht (105) auf den Wafer;
Sputtern einer ersten Keimschicht aus Ti/Cu auf die obere Oberfläche der ersten Polymerschicht (105);
Spinnen und Strukturieren einer Photoresist-Schicht auf die erste Keimschicht unter Verwendung von Standard-Fotolithografie-Prozessen;
Galvanisieren einer ersten Schicht aus Material (107) mit hoher Leitfähigkeit auf der Oberfläche des Photoresists und in die offenen Bereiche, die durch das Photoresist definiert werden, die die erste Keimschicht berührt und mehrere untere Spulenelemente, die mehrere zweite Kontakte enthalten, definiert, die mehreren ersten Öffnungen in der ersten Polymerschicht füllt, wodurch die erste Schicht aus Material (107) mit hoher Leitfähigkeit an die mehreren ersten Bondkontakte (104) gekoppelt wird;
Abtragen der Photoresist-Schicht unter Verwendung von Standard-Photoresist-Abtrageverfahren und Trockenätzen der freigelegten ersten Keimschicht;
Spinnen einer zweiten Polymerschicht (109) auf den Wafer, und Härten dieser, um die Polymerschicht auszuhärten;
Ablagern einer strukturierten Hartmaske auf dem Wafer unter Berührung der oberen Oberfläche des zweiten Polymers, wobei mehrere zweite Öffnungen in die zweite Polymerschicht geätzt werden, die sich von der oberen Oberfläche der zweiten Polymerschicht nach unten zu den mehreren zweiten Kontakten erstrecken;
Entfernen der Hartmaske;
Sputtern einer zweiten Keimschicht aus Ti/Cu auf die obere Oberfläche der ersten Polymerschicht (105);
Spinnen und Strukturieren einer Photoresist-Schicht auf die zweite Keimschicht unter Verwendung von Standard-Fotolithografie-Prozessen;
Galvanisieren einer Schicht aus Material mit hoher Leitfähigkeit in die offenen Bereiche, die durch das Photoresist definiert werden, die die zweite Keimschicht berührt und mehrere erste Durchkontaktierungen (110) definiert, wodurch die mehreren ersten Durchkontaktierungen (110) mit den mehreren ersten Bondkontakten (104) gekoppelt werden;
Abtragen der Photoresist-Schicht unter Verwendung von Standard-Photoresist-Abtrageverfahren und Trockenätzen der freigelegten zweiten Keimschicht;
Sputtern einer Schicht aus Titan auf die obere Oberfläche der zweiten Polymerschicht (109), die die zweite Polymerschicht (109) und die Oberseiten der mehreren ersten Durchkontaktierungen (110) berührt;
Ablagern eines lamellierten Magnetkerns, der mehrere Schichten aus abwechselnd Magnetfilm-Material und isolierendem Material (111) enthält, unter Verwendung eines Veeco Nexus PVDi Geräts, in einem Magnetfeld auf der oberen Oberfläche der Schicht aus Titan, wobei die mehreren Schichten aus abwechselnd magnetischem Material und isolierendem Material definiert sind, die mehreren ersten Durchkontaktierungen (110), die auf der Oberfläche der zweiten Polymerschicht (109) freigelegt sind, nicht zu berühren;
Strukturieren und Ätzen der mehreren Schichten aus abwechselnd magnetischem Material und isolierendem Material und der Titan-Schicht unter Verwendung von Standard-Photoresist-Prozessen, wobei das Photoresist dann unter Verwendung von Standardtechniken abgetragen wird;
Spinnen einer dritten Polymerschicht (112) auf den Wafer und Härten dieser, um die Polymerschicht auszuhärten;
Ablagern einer strukturierten Hartmaske auf dem Wafer, die die obere Oberfläche der dritten Polymerschicht berührt, wobei mehrere dritte Öffnungen in die dritte Polymerschicht geätzt werden, die sich von der oberen Oberfläche der dritten Polymerschicht nach unten zu den mehreren ersten Durchkontaktierungen erstrecken;
Entfernen der Hartmaske;
Sputtern einer dritten Keimschicht aus Ti/Cu auf die Oberfläche der dritten Polymerschicht (112);
Spinnen und Strukturieren einer Photoresist-Schicht auf die dritte Keimschicht unter Verwendung von Standard-Fotolithografie-Prozessen;
Galvanisieren einer zweiten Schicht aus Material (114) mit hoher Leitfähigkeit auf die Oberfläche des Photoresists und in die offenen Bereiche, die durch das Photoresist definiert sind, die die dritte Keimschicht berührt und mehrere obere Spulenelemente definiert, die mehrere zweite Kontakte enthalten, und die mehreren dritten Öffnungen in der dritten Polymerschicht füllt, wodurch die zweite Schicht aus Material (114) mit hoher Leitfähigkeit mit den mehreren ersten Bondkontakten (104) gekoppelt werden;
Abtragen der Photoresist-Schicht unter Verwendung von Standard-Photoresist-Abtrageprozessen, und Trockenätzen der freigelegten ersten Keimschicht;
Ablagern einer vierten Polymerschicht (116), die die dritte Polymerschicht (112) und die zweite Schicht aus Material (114) mit hoher Leitfähigkeit berührt, wobei die vierte Polymerschicht (116) Öffnungen enthält, die sich von der oberen Oberfläche der vierten Polymerschicht (116) nach unten durch die vierte Polymerschicht (116) zu der zweiten Schicht aus Material (114) mit hoher Leitfähigkeit erstrecken;
zweites Tempern (300-500 °C) der magnetischen Schichten in der Anwesenheit eines Magnetfeldes (0,1-1T), wobei das zweite Tempern ferner die leichte bzw. die harte Achse definiert; und Bilden von Lotkugeln in den Öffnungen, die in der vierten Polymerschicht (116) gebildet sind, die die zweite Schicht aus Material (114) mit hoher Leitfähigkeit berühren.

8. Verfahren zum Bilden einer integrierten magnetischen Vorrichtung nach Anspruch 7, wobei die zweite Polymerschicht (109) aus der Gruppe der Polymere SU8 3000 oder PI-2622 ausgewählt wird, wobei dann, wenn PI-2622 ausgewählt wird, ein CMP-Prozess verwendet wird, um die Oberfläche zu ebenen, und wobei dann, wenn SU8 3000 anstelle von PI-2622 für die zweite Polymerschicht verwendet wird, CMP nicht erforderlich ist, da SU8 3000 für die erforderliche Toleranz weitgehend selbstebnend ist.

9. Verfahren zum Bilden einer integrierten magnetischen Vorrichtung nach Anspruch 7, wobei jede magnetische Schicht gesputtert wird, wobei ihre Dicken, mit einem 10 nm AlN-Dielektrikum dazwischen, in einem Bereich von 0,1 µm bis 3 µm liegen, wobei die Gesamtdicke des lamellierten Magnetkerns zwischen 5 µm und 15 µm beträgt, das Sputtern in der Anwesenheit eines Magnetfeldes erfolgt, um die leichte Achse des magnetischen Materials zu bestimmen, und wobei die Orientierung derart ist, dass das B-Feld in den mehreren Schichten aus abwechselnd magnetischem Material und isolierendem Material in der Richtung der harten Achse liegt.

10. Verfahren zum Bilden einer integrierten magnetischen Vorrichtung nach Anspruch 7, wobei die Magnetfilm-Schichten aus der Gruppe von Ni80Fe20, Co90Ta5Zr5 oder FeAlN ausgewählt werden können.

11. Verfahren zum Bilden einer integrierten magnetischen Vorrichtung nach Anspruch 7, wobei die Magnetfilm-Schichten nach dem Sputtern in der Anwesenheit eines Magnetfelds bei 300-500 °C getempert werden, wodurch ferner die leichte bzw. die harte Achse definiert wird.

12. Verfahren zum Bilden einer integrierten magnetischen Vorrichtung nach Anspruch 7, wobei die erste und die zweite Schicht aus Material mit hoher Leitfähigkeit Kupfer mit einer Dicke von 20 µm enthalten.

13. Verfahren zum Bilden einer integrierten magnetischen Vorrichtung nach Anspruch 7, wobei die erste Polymerschicht (105) konfiguriert ist, als Spannungsentlastungsschicht zwischen einer Induktivität und dem Siliziumwafer zu agieren, wobei die Dicke der ersten Polymerschicht (105) zwischen 5 µm und 15 µm beträgt, und die erste Polymerschicht (105) aus der Gruppe der Polymere SU8 oder PI-2622 ausgewählt wird.

14. Verfahren zum Bilden einer integrierten magnetischen Vorrichtung nach Anspruch 7, wobei die erste Polymerschicht (105) PI-2622 entspricht, und dann nach dem Spinnen, dem Ablagern einer strukturierten Hartmaske auf dem Wafer, die die obere Oberfläche der ersten Polymerschicht berührt, wobei mehrere erste Öffnungen in die erste Polymerschicht geätzt werden, die sich von der oberen Oberfläche der ersten Polymerschicht nach unten zu den mehreren Bondkontakten erstrecken, und dem Entfernen der Hartmaske ausgehärtet wird, um die Polymerschicht zu härten.

15. Verfahren zum Bilden einer integrierten magnetischen Vorrichtung nach Anspruch 7, wobei die erste Polymerschicht (105) SU8 entspricht, die dann nach dem Spinnen, dem Ablagern und dem Strukturieren einer Photoresist-Schicht auf dem Wafer, die die obere Oberfläche der ersten Polymerschicht berührt, schwach ausgehärtet wird, wobei eine Belichtung durch eine Lichtquelle stattfindet, folgend auf die Belichtung, eine Nach-Belichtungs-Aushärtung durchgeführt wird, wobei das Photoresist und das nichtbelichtete SU8 dann weg entwickelt werden, wobei das SU8 dann nach dem Entwickeln hart ausgehärtet wird, und das SU8, das von der Lichtquelle belichtet worden ist, nach dem Entwicklungsprozess auf dem Wafer verbleiben wird.

## Revendications

1. Dispositif magnétique intégré, comprenant :
un substrat de plaque de silicium (101), une région active (102) sur celui-ci comprenant des transistors, des diodes, des condensateurs et des résistances couplés par une couche d'interconnexion conductrice (103) pour former un circuit actif, la région active (102) touchant la surface supérieure du substrat de plaque de silicium (101) et comportant une première pluralité de contacts de liaison (104), la couche d'interconnexion conductrice (103) comportant de multiples couches de matériau conducteur comprenant une couche isolante entre elles, les multiples couches de matériau conducteur étant couplées ensemble par une première pluralité de trous d'interconnexion (110) perçant leur couche isolante associée, le sommet de la couche d'interconnexion conductrice (103) étant une couche isolante, possédant des ouvertures pour exposer la première pluralité de contacts de liaison (104) ;
une couche de nitrure de silicium (106) recouvrant et touchant la couche isolante, possédant également des ouvertures pour exposer la première pluralité de contacts de liaison (104) ;
une première couche de polymère (105) déposée au-dessus de la couche de nitrure de silicium (106), comportant une première pluralité d'ouvertures s'étendant du sommet de la première couche de polymère (105) vers le bas jusqu'à la première pluralité de contacts de liaison (104) ;
une première couche de matériau à conductance élevée (107), déposée sur la surface supérieure de la première couche de polymère (105), remplissant la première pluralité d'ouvertures dans la première couche de polymère (105), formant la deuxième pluralité de trous d'interconnexion, couplant ainsi la première couche de matériau à conductance élevée (107) à la première pluralité de contacts de liaison (104), la première couche de matériau à conductance élevée (107) étant conçue pour former une pluralité d'éléments de bobine inférieurs et également comportant une deuxième pluralité de contacts de liaison (108) ;
une deuxième couche de polymère (109), touchant la première couche de polymère (105) et la première couche de matériau à conductance élevée (107), la surface supérieure de la deuxième couche de polymère (109) étant plane, la deuxième couche de polymère (109) comportant une deuxième pluralité d'ouvertures s'étendant de la surface supérieure de la deuxième couche de polymère (109) vers le bas jusqu'à la deuxième pluralité de contacts de liaison (108), la deuxième pluralité d'ouvertures dans la deuxième couche de polymère (109) étant remplie avec une troisième pluralité de trous d'interconnexion ;
de multiples couches de matériau de film magnétique et de matériau isolant (111) alternées déposées et définies sur la surface supérieure de la deuxième couche de polymère (109),
les multiples couches de matériau de film magnétique et de matériau isolant (111) alternées, telles que définies, ne touchant pas la troisième pluralité de trous d'interconnexion exposés sur la surface supérieure de la deuxième couche de polymère (109) ;
une troisième couche de polymère (112) étant déposée touchant la deuxième couche de polymère (109) et le sommet des multiples couches de matériau de film magnétique et de matériau isolant (111) alternées, la troisième couche de polymère (112) comportant une troisième pluralité d'ouvertures s'étendant de la surface supérieure de la troisième couche de polymère (112) vers le bas jusqu'aux surfaces supérieures de la troisième pluralité de trous d'interconnexion ;
une deuxième couche de matériau à conductance élevée (114) étant déposée sur la surface supérieure de la troisième couche de polymère (112), la deuxième couche de matériau à conductance élevée (114) remplissant la troisième pluralité d'ouvertures dans la troisième couche de polymère (112), formant une quatrième pluralité de trous d'interconnexion, couplant ainsi la deuxième couche de matériau à conductance élevée (114) de la première pluralité de contacts de liaison (104), la deuxième couche de matériau à conductance élevée (114) étant conçue pour former une pluralité d'éléments de bobine supérieurs et comportant également une troisième pluralité de contacts de liaison (115) ; et
une quatrième couche de polymère (116) étant déposée touchant la troisième couche de polymère (112) et le sommet de la deuxième couche de matériau à conductance élevée (114), la quatrième couche de polymère (116) comportant des ouvertures s'étendant de la surface supérieure de la quatrième couche de polymère (116) vers le bas jusqu'à la deuxième couche de matériau à conductance élevée (114), les ouvertures dans la quatrième couche de polymère (116) étant remplies avec des billes de soudure, les billes de soudure fournissant une connexion à une circuiterie extérieure.

2. Dispositif magnétique intégré selon la revendication 1, la première couche de polymère (105) étant conçue pour agir en tant que couche de relâchement de contrainte entre un inducteur et la plaque de silicium, l'épaisseur de la première couche de polymère (105) étant comprise entre 5 µm et 15 µm, et la première couche de polymère (105) étant choisie dans le groupe des polymères SU8 et PI-2622.

3. Dispositif magnétique intégré selon la revendication 1, la deuxième couche de polymère (109) étant choisie dans le groupe des polymères SU8 3000 et PI-2622.

4. Dispositif magnétique intégré selon la revendication 1, chaque couche de film magnétique possédant une épaisseur qui se situe dans la plage de 0,1 µm à 3 µm avec un diélectrique d'AlN de 10 nm entre elles, et la composition des couches de film magnétique étant choisie dans le groupe de Ni80Fe20, Co90Ta5Zr5 et FeAlN.

5. Dispositif magnétique intégré selon la revendication 1, l'épaisseur totale de noyau magnétique stratifié étant comprise entre 5 et 15 µm.

6. Dispositif magnétique intégré selon la revendication 1, la première et la deuxième couche de matériau à conductance élevée comportant du cuivre avec une épaisseur de 20 µm.

7. Procédé de formation d'un dispositif magnétique intégré, comprenant :
la mise à disposition d'une plaque de circuits intégrés formée de manière conventionnelle, les contacts de liaison de chacun des circuits intégrés étant exposés à travers des ouvertures dans la couche isolante au sommet de la couche d'interconnexion conductrice (103) ;
le dépôt et la définition d'une couche de nitrure de silicium sur la plaque, la couche de nitrure de silicium (106) touchant la couche isolante au sommet de la couche d'interconnexion conductrice (103) et exposant les plots de liaison exposés à travers les ouvertures dans la couche isolante au sommet de la couche d'interconnexion conductrice (103) ; et en utilisant un procédé de motif et gravure, les contacts de liaison étant exposés à travers des ouvertures dans la couche de nitrure de silicium (106) ;
le filage et la formation de motif d'une première couche de polymère (105) sur la plaque ;
la pulvérisation d'une première couche de germe de Ti/Cu sur la surface supérieure de la première couche de polymère (105) ;
le filage et la formation de motif d'une couche de photorésine sur la première couche de germe à l'aide de procédés standards de photolithographie ;
l'électrodéposition d'une première couche de matériau à conductance élevée (107) sur la surface de la photorésine et
dans les zones ouvertes définies par la photorésine, touchant la première couche de germe et définissant une pluralité d'éléments de bobine inférieurs qui comportent une deuxième pluralité de contacts, remplissant la première pluralité d'ouvertures dans la première couche de polymère, couplant ainsi la première couche de matériau à conductance élevée (107) à la première pluralité de contacts de liaison (104) ;
le décapage de la couche de photorésine, à l'aide de méthodes standards de décapage de photorésine et la gravure sèche de la première couche de germe exposée ;
le filage d'une deuxième couche de polymère (109) sur la plaque, et la cuisson de celle-ci pour durcir la couche de polymère ;
le dépôt d'un masque dur à motif sur la plaque touchant la surface supérieure du deuxième polymère, une deuxième pluralité d'ouvertures étant gravée dans la deuxième couche de polymère s'étendant de la surface supérieure de la deuxième couche de polymère vers le bas jusqu'à la deuxième pluralité de contacts ;
l'élimination du masque dur ;
la pulvérisation d'une deuxième couche de germe de Ti/Cu sur la surface supérieure de la première couche de polymère (105) ;
le filage et la formation de motif d'une couche de photorésine sur la deuxième couche de germe à l'aide de procédés standards de photolithographie ;
l'électrodéposition d'une couche de matériau à conductance élevée dans les zones ouvertes définies par la photorésine, touchant la deuxième couche de germe et définissant une première pluralité de trous d'interconnexion (110), couplant ainsi la première pluralité de trous d'interconnexion (110) à la première pluralité de contacts de liaison (104) ;
le décapage de la couche de photorésine, à l'aide de méthodes standards de décapage de photorésine et la gravure sèche de la deuxième couche de germe exposée ;
la pulvérisation d'une couche de titane sur la surface supérieure de la deuxième couche de polymère (109), touchant la deuxième couche de polymère (109) et les sommets de la première pluralité de trous d'interconnexion (110) ;
le dépôt d'un noyau magnétique stratifié comprenant de multiples couches de matériau de film magnétique et de matériau isolant (111) alternées à l'aide d'un outil Nexus PVDi de Veeco, dans un champ magnétique, sur la surface supérieure de la couche de titane, les multiples couches de matériau magnétique et de matériau isolant alternées étant définies de sorte à ne pas toucher la première pluralité de trous d'interconnexion (110) exposée sur la surface supérieure de la deuxième couche de polymère (109) ;
la formation de motif et la gravure des multiples couches de matériau magnétique et de matériau isolant alternées et de la couche de titane, à l'aide de procédés standards de photorésine, la photorésine étant ensuite décapée à l'aide de techniques standards ;
le filage d'une troisième couche de polymère (112) sur la plaque et la cuisson de celle-ci pour durcir la couche de polymère ;
le dépôt d'un masque dur à motif sur la plaque touchant la surface supérieure de la troisième couche de polymère, une troisième pluralité d'ouvertures étant gravée dans la troisième couche de polymère s'étendant de la surface supérieure de la troisième couche de polymère vers le bas jusqu'à la première pluralité de trous de connexion ;
l'élimination du masque dur ;
la pulvérisation d'une troisième couche de germe de Ti/Cu sur la surface supérieure de la troisième couche de polymère (112) ;
le filage et la formation de motif d'une couche de photorésine sur la troisième couche de germe à l'aide de procédés standards de photolithographie ;
l'électrodéposition d'une deuxième couche de matériau à conductance élevée (114) sur la surface de la photorésine et dans les zones ouvertes définies par la photorésine, touchant la troisième couche de germe et définissant une pluralité d'éléments de bobine inférieurs qui comportent une deuxième pluralité de contacts, et le remplissage de la troisième pluralité d'ouvertures dans la troisième couche de polymère, couplant ainsi la deuxième couche de matériau à conductance élevée (114) à la première pluralité de contacts de liaison (104) ;
le décapage de la couche de photorésine, à l'aide de méthodes standards de décapage de photorésine et la gravure sèche de la première couche de germe exposée ;
le dépôt d'une quatrième couche de polymère (116), touchant la troisième couche de polymère (112) et la deuxième couche de matériau à conductance élevée (114), la quatrième couche de polymère (116) comportant des ouvertures s'étendant de la surface supérieure de la quatrième couche de polymère (116) vers le bas à travers la quatrième couche de polymère (116) jusqu'à la deuxième couche de matériau à conductance élevée (114) ;
la soumission des couches magnétiques à un deuxième recuit (300 à 500 °C) en présence d'un champ magnétique (0,1 à 1 T), le deuxième recuit définissant en outre les axes faciles/durs ; et
la formation de billes de soudure dans les ouvertures formées dans la quatrième couche de polymère (116), touchant la deuxième couche de matériau à conductance élevée (114).

8. Procédé de formation d'un dispositif magnétique intégré selon la revendication 7, la deuxième couche de polymère (109) étant choisie dans le groupe des polymères SU8 3000 et PI-2622, où, si le PI-2622 est choisi, un procédé CMP est utilisé pour aplanir la surface, et où, si le SU8 3000 est utilisé au lieu du PI-2622 pour la deuxième couche de polymère, le CMP n'est pas requis puisque le SU8 3000 est largement auto-planarisant à la tolérance requise.

9. Procédé de formation d'un dispositif magnétique intégré selon la revendication 7, chaque couche de film magnétique étant pulvérisée, avec une épaisseur dans la plage de 0,1 µm à 3 µm avec un diélectrique d'AlN de 10 nm entre elles, l'épaisseur totale magnétique stratifiée étant comprise entre 5 et 15 µm, la pulvérisation étant accomplie en présence d'un champ magnétique pour déterminer l'axe facile du matériau magnétique, et l'orientation étant telle que le champ B dans les multiples couches de matériau magnétique et de matériau isolant alternées est dans la direction de l'axe dur.

10. Procédé de formation d'un dispositif magnétique intégré selon la revendication 7, les couches de film magnétique pouvant être choisies dans le groupe de Ni80Fe20, Co90Ta5Zr5 et FeAlN.

11. Procédé de formation d'un dispositif magnétique intégré selon la revendication 7, les couches de film magnétique étant soumises à un recuit de 300 à 500 °C, en présence d'un champ magnétique après pulvérisation, définissant en outre les axes facile/dur.

12. Procédé de formation d'un dispositif magnétique intégré selon la revendication 7, la première et la deuxième couche de matériaux à conductance élevée comportant du cuivre avec une épaisseur de 20 µm.

13. Procédé de formation d'un dispositif magnétique intégré selon la revendication 7, la première couche de polymère (105) étant conçue pour agir en tant que couche de relâchement de contrainte entre un inducteur et la plaque de silicium, l'épaisseur de la première couche de polymère (105) étant comprise entre 5 µm et 15 µm, et la première couche de polymère (105) étant choisie dans le groupe des polymères SU8 et PI-2622.

14. Procédé de formation d'un dispositif magnétique intégré selon la revendication 7, la première couche de polymère (105) étant le PI-2622, et étant ensuite cuite après filage pour durcir la couche de polymère, déposant un masque dur à motif sur la plaque touchant la surface supérieure de la première couche de polymère, une première pluralité d'ouvertures étant gravée dans la première couche de polymère s'étendant de la surface supérieure de la première couche de polymère vers le bas jusqu'à la pluralité de contacts de liaison, éliminant le masque dur.

15. Procédé de formation d'un dispositif magnétique intégré selon la revendication 7, la première couche de polymère (105) étant le SU8, étant ensuite cuite doucement après filage, dépôt et formation d'un motif d'une couche de photorésine sur la plaque touchant la surface supérieure de la première couche de polymère, une exposition par une source de lumière ayant lieu, suivant l'exposition, une cuisson post-exposition étant réalisée, la photorésine et le SU8 non exposé étant ensuite développés, le SU8 étant ensuite durci durement après développement, et le SU8 exposé à la source de lumière restant sur la plaque après le procédé de développement.
